# FASCICULE DE BREVET EUROPEEN

(11) **EP 1 968 885 B1**
(45) Date de publication et mention de la délivrance du brevet: **25.04.2012**
(21) Numéro de dépôt: 07712639.9
(22) Date de dépôt: 05.01.2007
(51) Int. Cl.: B81C 99/00, H01L 41/24

(54) **PREPARATION DE MICROCOMPOSANTS PIEZOELECTRIQUES SUSPENDUS PAR LA METHODE DE LA COUCHE EPAISSE SACRIFICIELLE**
HERSTELLUNG VON PIEZOELEKTRISCHEN AUFGEHÄNGTEN MIKROKOMPONENTEN NACH DEM OPFER-DICKSCHICHTVERFAHREN
PRODUCTION OF PIEZOELECTRIC SUSPENDED MICROCOMPONENTS BY THE SACRIFICIAL THICK FILM METHOD

(30) Priorité: 06.01.2006 FR 0600124
(43) Date de publication de la demande: 17.09.2008
(73) Titulaire: Centre National de la Recherche Scientifique, 75016 Paris (FR)
(72) Inventeur: LUCAT, Claude, 33610 Cestas (FR); MENIL, Francis, 33650 Saint-selve (FR); DEBEDA-HICKEL, Hélène, 33170 Gradignan (FR); GINET, Patrick, 33800 Bordeaux (FR)
(74) Mandataire: Sueur, Yvette
(86) Numéro de dépôt international: PCT/FR2007/000013
(87) Numéro de publication internationale: WO 2007/077397

(56) Documents cités:
- FR-A1- 2 570 223
- US-B1- 6 738 600
- PRANONSATIT S ET AL: "Self-assembled screen-printed microwave inductors" ELECTRONICS LETTERS, IEE STEVENAGE, GB, vol. 41, no. 23, 10 novembre 2005 (2005-11-10), pages 1287-1288, XP006025608 ISSN: 0013-5194

## Description

La présente invention concerne la préparation d'un microcomposant piézoélectrique suspendu par la méthode de la couche épaisse sacrificielle.

De nombreux composants présentant des dimensions micrométriques ou millimétriques sont utilisés pour l'élaboration de divers microsystèmes notamment dans les domaines de la microélectronique, de la microrobotique, de la micromécanique, de la microfluidique, du micromagnétisme, de la microthermique, de la microoptique, ou de la microchimie. Les différents secteurs économiques concernés sont notamment ceux de l'automobile, du spatial, de l'aéronautique, de la domotique, de la santé, de la biologie, de la chimie, de l'agroalimentaire, de l'environnement. Ces composants peuvent présenter des formes très diverses et ils peuvent être constitués par des matériaux variés, selon leur destination. Ils sont utilisés dans des microsystèmes désignés généralement par MEMS (MicroElectroMechanicalSystems, c'est-à-dire systèmes microélectromécaniques). Parmi les MEMS qui sont commercialisés, on peut citer notamment les microcapteurs (d'inertie, de pression, ou chimiques), les microactionneurs (microvalve, microrelais, micropompes) et des microsystèmes dédiés à l'analyse chimique par exemple. Les MEMS comportent généralement une partie mobile, un capteur et/ou un actionneur associé à une électronique de commande et de traitement.

Il est connu de fabriquer des composants monocouche et/ ou multicouches par des procédés indirects tels que la technologie silicium, la techniques PCB (Printed Circuit Board, ou plaque à circuit imprimé) et la technique LTCC. (Low Temperature Cofired Ceramic, ou céramique co-cuite à basse température). Ces procédés sont cependant longs et coûteux car ils comprennent de nombreuses étapes de micro usinage (masquage, gravure, dépôts, etc.).

Il est également connu d'utiliser des procédés directs tels que les techniques de prototypage (jet d'encre, extrusion, microstéréolithographie) pour l'élaboration de microcomposants monocouche et/ou multicouches. Cependant, ces techniques ne sont pas adaptées à la fabrication collective de composants.

G. Stecher, R. Bosch [«Free supporting structures in thickfilm technology : a substrate integrated sensor » Stuttgart, 1987, Proc. 8th European Microelectronics Conf. p.421-427*]* décrivent un procédé d'élaboration d'un microcomposant consistant à déposer par sérigraphie une couche provisoire constituée par un matériau carboné sur une zone d'un substrat, puis à déposer une couche active de céramique ou de verre sur la couche de matériau provisoire et sur une zone du substrat non recouverte par le matériau carboné, et finalement à détruire la couche provisoire. L'utilisation d'un matériau carboné comme couche provisoire présente divers inconvénients. Lorsque la matière active doit être traitée à une certaine température en vue de sa consolidation (ce qui est le cas des céramiques par exemple), il est nécessaire de travailler sous atmosphère neutre (azote ou argon) afin d'éviter la dégradation de la couche provisoire avant la consolidation de la couche active. Par ailleurs, cette atmosphère peut être rédhibitoire pour la fabrication de nombreux matériaux instables sous cette atmosphère.
Le brevet US 6 738 600 B1 décrit un procédé de type couche épaisse qui est utilisé afin de produire un commutateur électrostatique. Au cours du procédé, une couche sacrificielle est produite. Elle est supprimée à la fin du procédé créant ainsi un élément suspendu mobile. La demande de brevet publiée FR 2 570 223 A1 divulgue la production d'une couche piézoélectrique dans le contexte d'un procédé de couche épaisse. Dans une forme du procédé de réalisation, une encre contenant du PbTiZrO₃, du PbO et un liant organique est déposée par sérigraphie, puis est soumise à une cuisson. Ce procédé vise à la production d'un capteur solidaire d'un substrat en céramique.

Le but de la présente invention est de proposer un procédé par sérigraphie qui permet d'obtenir de manière fiable et relativement simple un microcomposant piézoélectrique suspendu, par dépôt de couches provisoires et de couches définitives chimiquement et mécaniquement stables, les couches provisoires pouvant être éliminées sans précautions particulières, quelles que soient la composition des couches définitives formant in fine le microcomposant.

Le procédé proposé est destiné à fabriquer un microcomposant suspendu piézoélectrique qui comprend une électrode inférieure (3) et une électrode supérieure (4), ledit procédé consistant à :
1) déposer sur un substrat d'alumine, une première couche provisoire d'une encre (P) constituée par une résine thermodurcissable epoxy contenant du SrCO₃ comme charge minérale, et à consolider ladite couche ;
2) déposer, de part et d'autre de la première couche provisoire d'encre (P), une première couche d'encre à l'or (M1) sous forme de deux zones, et à consolider partiellement ladite couche (M1) ;
3) déposer une deuxième couche d'encre à l'or (M'1) selon un motif représentant la forme de l'électrode inférieure (3), uniquement au dessus de la première couche provisoire d'encre (P) et de façon que ladite deuxième couche d'entre à l'or (M'1) touche une première desdites deux zones formant la première couche d'entre à l'or (M1), et à consolider partiellement ladite couche (M'1) ;
4) déposer, uniquement sur la partie de la deuxième couche d'encre à l'or (M'1) représentant l'électrode inférieure (3) une quatrième couche d'encre (M2), ladite quatrième couche contenant un liant organique et une poudre constituée de PbZr_{0,5}Ti_{0,5}O₃ et d'eutectique Pb0/PbF₂, et à consolider partiellement ladite couche (M2) ;
5) déposer une deuxième couche provisoire d'encre (P') constituée par une résine thermodurcissable epoxy contenant du SrCO₃ comme charge minérale, pour isoler électriquement les deux électrodes (3, 4), la deuxième couche provisoire d'encre (P') étant disposée directement sur une surface libre de la première couche provisoire d'encre (P) entre la deuxième couche d'encre à l'or (M'1) et la deuxième desdites deux zones formant la première couche d'encre à l'or (M1), et à consolider ladite couche (P') ;
6) déposer une troisième couche d'encre à l'or (M"1), ladite couche étant contenue dans le motif de la quatrième couche d'encre (M2) de façon à toucher la deuxième desdites deux zones formant la première couche d'encre à l'or (M1), la troisième couche d'encre à l'or (M"1) représentant la forme de l'électrode supérieure (4), et à effectuer une consolidation totale, ladite consolitation totale étant effectuée par un traitement thermique ;
7) éliminer ensuite totalement le matériau des deux couches provisoire d'encre (P, P') ; les encores (M1, M'1, M"1, M2, P et P') étant déposées par coulage ou par extrusion.

Dans un mode de réalisation particulièrement préféré, les couches P et les couches M sont déposées par coulage, le coulage étant effectué de préférence par sérigraphie.

Les différentes couches déposées ont de préférence une épaisseur allant de 1 µm à 1 mm, de préférence de 1 µm à 500 µm, plus particulièrement de 1 à 100 µm. Pour l'élaboration d'un microcomposant donné, l'épaisseur de chaque couche d'encre est déterminée en fonction de l'épaisseur du ou des films de matériau M constituant ledit microcomposant et du retrait éventuel subi par chaque couche d'encre lors de sa consolidation totale ou partielle. La détermination des épaisseurs des couches à déposer est à la portée de l'homme de métier.

Lorsque Les explications suivantes servent à éclaircir l'arrière-plan de l'invention un procédé de couche épaisse comprend le dépôt de plusieurs couches d'encre P et/ou de plusieurs couches d'encre M, les encres P utilisées peuvent être identiques ou différentes, et les encres M utilisées peuvent être identiques ou différentes.

Dans la suite, l'encre P utilisée pour le dépôt de la n^{ème} couche de type P est désignée par encre Pn et la couche correspondante est désignée par couche Pn, et l'encre M de la n^{ème} couche de type M est désignée par encre Mn et la couche correspondante est désignée par couche Mn. Le matériau obtenu par consolidation d'une couche Mn est désigné par matériau Mn. n est un nombre entier, généralement inférieur à 10.

Une encre P est constituée soit par une résine thermodurcissable qui contient éventuellement une charge minérale, soit par un mélange comprenant un matériau minéral et un véhicule organique.

Comme exemples de résine thermodurcissable d'une encre P, on peut citer les résines époxy, les résines phénoliques, les résines acryliques, les polyuréthanes, les poly(vinylester) et les polyesters.

Le véhicule organique d'une encre P contient au moins un liant provisoire (par exemple l'éthylcellulose, un méthacrylate ou un méthylméthacrylate), au moins un solvant (par exemple le terpinéol ou l'acétate de butylcarbitol), éventuellement au moins un composé choisi parmi les gélifiants, les plastifiants, les tensioactifs et les lubrifiants.

La charge minérale d'une encre P peut être une poudre d'un matériau choisi parmi
• les chlorures de métal alcalin ou de métal alcalino-terreux, les nitrates de métal alcalin ou de métal alcalino-terreux, les nitrites de métal alcalin ou de métal alcalino-terreux, les hydroxydes de métal alcalin ou de métal alcalino-terreux, les carbonates de métal alcalin ou de métal alcalino-terreux, les sulfates de métal alcalin ou de métal alcalino-terreux, les phosphates de métal alcalin ou de métal alcalino-terreux, et les fluorures.de métal alcalin ou de métal alcalino-terreux, les borures de métal alcalin ou de métal alcalino-terreux ;
• les poudres métalliques (par exemple Ag, Cu, Au, Fe, Ni, Ti, Sn), les poudres de verre et les poudres de céramique, les poudres de composés précurseurs organométalliques.
• les oxydes (par exemple Al₂O₃, ZrO₂, TiO₂ et Y₂O₃), les nitrures (par exemple BN, TaN, TiN et Si₃N₄), les carbures (par exemple TaC, TiC et WC).

L'élimination du matériau P lors de l'étape finale du procédé est effectuée soit dans l'eau, soit un milieu acide, suivant la solubilité du matériau à éliminer.

Lorsque l'encre P contient une résine thermodurcissable, la consolidation partielle est effectuée par polymérisation de la résine à une température comprise entre 120°C et 220°C pendant une durée de 20 min à 2 h.

Lorsque l'encre P contient un véhicule organique, la couche déposée est consolidée partiellement par un étuvage à une température comprise entre 120 et 150°C, pendant une durée de 10 à 20 min, puis consolidée par une cuisson entre 500 et 1200°C.

Pour les deux types d'encre P, lorsque la charge minérale est l'alumine, un carbure ou un borure, elle agit en outre comme barrière de diffusion lors de la cuisson à haute température.

Une encre M comprend un véhicule organique temporaire et un constituant minéral précurseur du matériau M constituant le microcomposant à élaborer. Le véhicule organique d'une encre M est choisi parmi les matériaux définis pour le véhicule organique d'une encre P, étant entendu que les véhicules des encres P et des encres M utilisées dans un processus peuvent être identiques ou différents. Le matériau minéral précurseur du matériau M peut être une poudre de métal, une poudre de verre, une poudre céramique ou une poudre des composé(s) organométallique(s), ledit constituant minéral ayant par exemple des propriétés diélectrique, isolante, conductrice ionique, conductrice électronique, optique ou magnétique. Si le matériau M est un métal, il est différent d'un métal alcalin et d'un métal alcalino-terreux. Par céramique, on entend notamment un oxyde, un nitrure, un oxynitrure, un carbure, un carbonitrure, un fluorure ou un oxyfluorure. Par vitrocéramique, on entend un verre partiellement recristallisé.

Comme exemple de matériau minéral précurseur d'un métal M, on peut citer une poudre de Ag, de Au, de Cu, de Fe, de Ni, de Ti ou de Sn, ou une poudre d'un mélange d'au moins deux de ces métaux, ou une poudre de composé(s) organométallique(s).

Une encre M peut contenir en outre si nécessaire un additif qui permet l'accrochage de la couche au substrat. L'additif peut être par exemple du verre ou un oxyde réactif. L'additif est choisi notamment en fonction de la compatibilité de son coefficient de dilatation thermique avec celui de la couche M1 en contact avec le substrat et celui dudit substrat, et pour un additif du type verre, en fonction de la compatibilité de la température de ramollissement avec la température de consolidation finale du microcomposant.

La consolidation partielle d'une couche d'encre M vise à évaporer le solvant organique (par exemple (par exemple le terpinéol ou l'acétate de butylcarbitol) contenu dans l'encre. La consolidation consiste en un traitement thermique à une température et pendant une durée suffisante pour évaporer ledit solvant organique. Ce traitement thermique peut être effectué en étuve à une température comprise entre 120 et 150°C, pendant une durée de 10 à 20 min.

La consolidation totale d'une couche d'encre M a pour but l'obtention d'une couche densifiée plus ou moins poreuse, par exemple par frittage. La consolidation totale est obtenue par un traitement thermique à une température et une durée supérieures à celles qui sont utilisées pour la consolidation partielle. Elle peut être effectuée par exemple à une température comprise entre 600°C et 1200°C, pendant une durée de 15 min à 1 h. La consolidation peut comporter une étape supplémentaire, sous forme d'un recuit de plusieurs heures, pour améliorer la tenue mécanique et/ou la microstructure du microcomposant. La température du recuit est de préférence inférieure d'une centaine de °C à celle du la consolidation totale.

Aux températures les plus basses, le traitement thermique d'une couche d'encre M provoque en outre d'abord l'élimination du polymère (résine thermodurcissable) ou du véhicule organique (éthylcellulose ou terpinéol) des encres P déposées au préalable, puis éventuellement aux températures plus élevées, la décomposition des additifs minéraux desdites encres P. Suivant sa nature, le polymère de l'encre P peut se décomposer dès que la température atteint 120°C, jusqu'à 450°C pour une résine époxy, au cours de la montée en température.

De manière générale, la composition d'une encre P ou d'une encre M doit répondre à des critères de viscosité, de stabilité chimique et physique compatible avec la technique d'extrusion ou de coulage notamment par sérigraphie. La viscosité est de préférence comprise entre 100 et 2000 Pa.s.

Dans un exemple, le procédé comprend une étape supplémentaire, au cours de laquelle une opération supplémentaire est effectuée, par exemple le dépôt d'une plaque préconstituée d'un matériau M, une métallisation par un procédé électrochimique, chimique, PVD, plasma, jet d'encre, etc., ou une encapsulation. Ladite étape supplémentaire peut être effectuée avant ou après l'étape finale d'élimination de la (des) couche(s) d'encre P, ou entre le dépôt de deux couches d'encre M et/ou d'encre P.

Un microcomposant obtenu par le procédé de l'invention est constitué par plusieurs films de matériau M ayant chacun une épaisseur allant de 1 µm à 500 µm, de préférence de 1 µm à 100 µm. Le microcomposant a généralement une épaisseur de l'ordre du millimètre.

Le procédé selon l'invention permet d'obtenir un microcomposant piézoélectrique suspendu fixé sur substrat d'alumine.

Un microcomposant exemplaire qui est constitué par un seul film de matériau M1 et qui est désolidarisé du substrat est obtenu lorsqu'un procédé de couche épaisse mis en oeuvre dans les conditions suivantes :
- la première couche déposée sur le substrat est déposée à partir d'une encre P1 ;
- la deuxième couche est déposée à partir d'une encre M1, selon un motif entièrement porté par la couche d'encre P1.

Un microcomposant qui est constitué par plusieurs films de matériau M et qui est désolidarisé du substrat est obtenu lorsque le procédé est mis en oeuvre dans les conditions suivantes :
- la première couche déposée sur le substrat est déposée à partir d'une encre P1 ;
- chacune des couches successives déposées à partir d'encres M est déposée selon un motif entièrement porté par la couche d'encre P1 et par les éventuelles autres couches déposées à partir d'encres P.

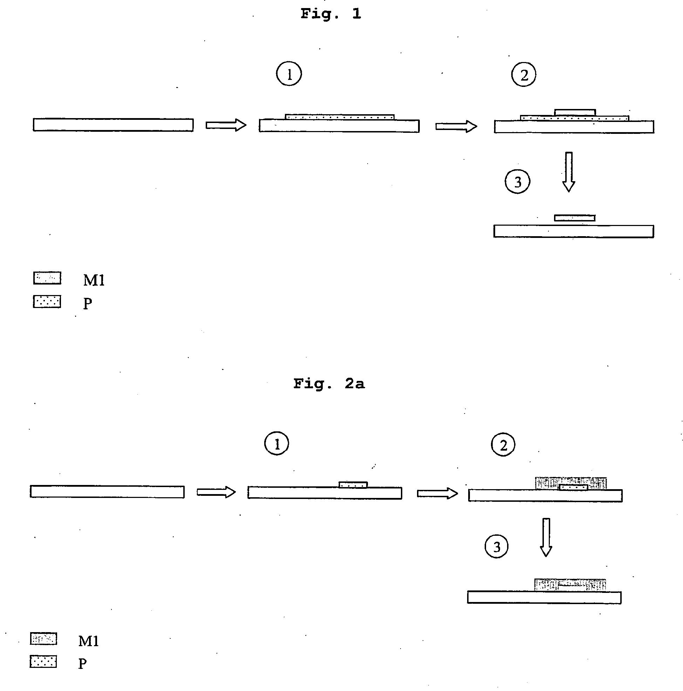

La figure 1 représente schématiquement la succession des étapes requises pour l'obtention d'un microcomposant libre comprenant un seul film M.

Sur le substrat initial, on dépose une couche d'encre P selon un motif prédéterminé, puis la couche d'encre M. Après consolidation de la couche d'encre M, on élimine la couche d'encre P et l'on obtient un élément libre constitué uniquement par une couche de matériau M libérée du substrat.

Un microcomposant fixé sur un substrat est obtenu lorsque le motif selon lequel au moins l'une des encres M est déposée, n'est pas entièrement compris dans le motif selon lequel la couche P1 est déposée.

Le procédé de couche épaisse permet de déposer des couches d'encre selon des motifs ayant des formes quelconques. Un motif peut être sous forme d'une surface continue ayant une géométrie donnée ou d'une surface discontinue formée d'au moins deux zones disjointes. La combinaison de couches d'encre déposées selon des motifs formant une surface continue et de couches d'encre déposées selon des motifs formant une surface discontinue permet d'élaborer des microcomposants ayant une architecture très variée.

Le dépôt d'une couche d'encre M selon un motif formant une surface continue (par exemple selon un motif représentant un rectangl.e ou un disque) donne un film de matériau M parallèle au plan du substrat.

Le dépôt d'une couche d'encre M selon un motif constitué par des zones disjointes (par exemple plusieurs îlots) donne une couche de matériau M formée de plusieurs plots perpendiculaires au plan du substrat.

Le dépôt d'une couche d'encre M selon un motif constitué par une ligne fermée (par exemple un cercle ou le contour d'un quadrilatère) donne une couche de matériau M formée par un mur perpendiculaire au plan du substrat. Dans un exemple, la ligne fermée peut être interrompue dans une ou plusieurs zones, et la couche qui en résulte forme un ensemble de murs perpendiculaires au plan du substrat.

Un motif selon lequel une couche d'encre M est déposé peut être délimité par la forme d'une couche d'encre P déposée avant ladite couche d'encre M.

Dans ce qui suit, lorsqu'il s'agit de la structure du microcomposant obtenu, une couche de matériau M obtenue sous forme de film parallèle au plan du substrat sera désignée par film horizontal, et une couche de matériau M obtenue sous forme de plots ou de murs perpendiculaires au plan du substrat sera désigné par plots ou murs verticaux.

La combinaison des films horizontaux et de plots et/ou de murs verticaux de matériaux M tels que définis ci-dessus permet d'obtenir des microcomposants ayant différentes architectures. Les architectures sont généralement une combinaison d'éléments structurels de type film, de type pont, de type poutre, ou de type cage.

L'obtention d'un microcomposant sous forme d'un film détaché du substrat sur lequel il a été formé est illustré par la figure 1.

Un élément du type pont peut être considéré comme la combinaison de plots et/ou de murs supportant un film, en délimitant un espace libre sous le film.

Selon un 1^{er} exemple, une structure en pont comprenant deux plots qui supportent un film en délimitant un espace libre sous le film, peut être élaboré par un procédé qui présente les caractéristiques suivantes :
- au cours d'une 1^{ère} étape, on dépose sur le substrat initial, une couche d'encre P1 selon un motif Mo1 correspondant audit espace libre ;
- au cours d'une 2^{éme} étape, on dépose sur le substrat et sur la couche P1, une couche d'encre M1 selon un motif Mo2 qui déborde du motif Mo1 sur une partie de sa périphérie ;
- au cours d'une 3^{éme} étape, on élimine totalement la couche P41 et l'on obtient un microcomposant constitué par un film de matériau M1 qui repose sur deux plots de matériau M1.

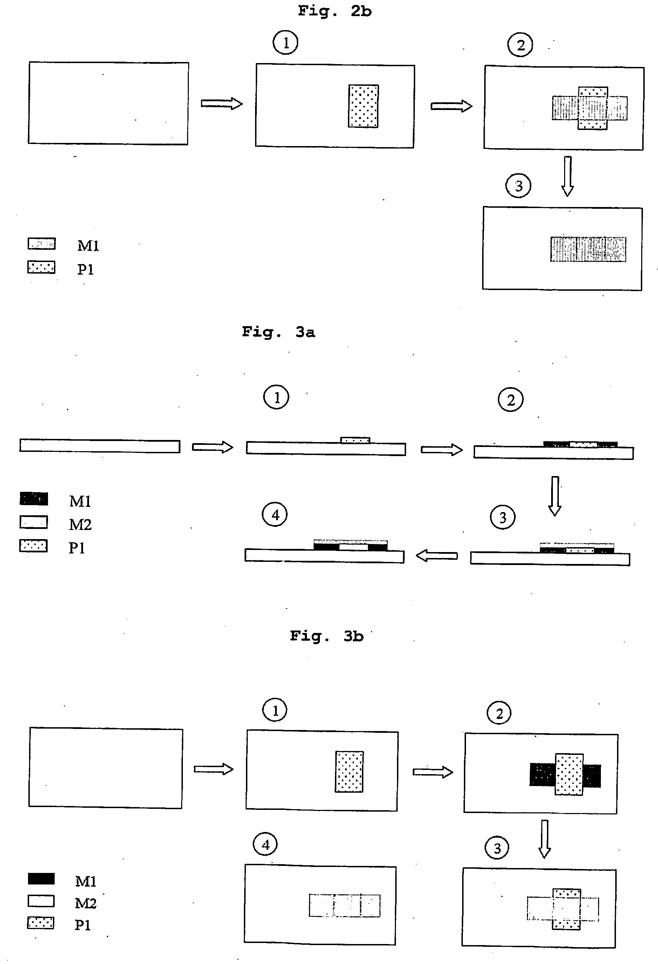

Les figures 2a et 2b illustrent un cas particulier de ce premier mode de mise en oeuvre du procédé de l'invention pour l'élaboration d'un élément de type "pont". La figure 2a est une vue latérale et la figure 2b est une vue par-dessus du substrat lors des différentes étapes.

Tel qu'illustré sur les figures 2a et 2b, le procédé d'élaboration d'un pont présente les caractéristiques suivantes :
- au cours d'une 1^{ère} étape, on dépose sur le substrat initial, une couche d'encre P1 selon un motif Mo1 rectangulaire dont les côtés correspondant à la longueur sont désignés par Lp et les côtés correspondant à la largeur sont désignés par lp ;
- au cours d'une 2^{ème} étape, on dépose sur le substrat et sur la couche P1, une couche d'encre M1 selon un motif Mo2 rectangulaire dont la longueur est désigné par Lm et la largeur est désignée par lm, puis on consolide totalement la couche d'encre M1, avec les conditions suivantes :
   o Lp et lm sont parallèles entre eux ;
   o lp et Lm sont parallèles entre eux ;
   o Lp≥lm ;
   o Lm>lp ;
   o le motif Mo1 et le motif Mo2 ont une zone centrale commune ;
- au cours d'une 3^{ème} étape, on élimine totalement la couche P1 et l'on obtient un microcomposant constitué par un film de matériau M1 qui repose sur deux plots de matériau M1.

Selon un 2ème exemple, une structure en pont comprenant deux plots supportant un film, les plots et le film délimitant un espace libre, peut être élaboré par un procédé qui présente les caractéristiques suivantes :
- au cours d'une 1^{ère} étape, on dépose sur le substrat initial, une couche d'encre P1 selon un motif Mo1 correspondant audit espace libre ;
- au cours d'une 2^{ème} étape, on dépose sur le substrat une couche d'encre M1 selon un motif Mo2 comprenant deux zones disjointes, chacune desdites zones disjointes étant adjacente à la couche d'encre P1 sur une partie de sa périphérie, puis l'on consolide au moins partiellement la couche d'encre M1 ;
- au cours d'une 3^{ème} étape, on dépose une couche d'encre M2 selon un motif Mo3 qui recouvre sans débordement la surface des deux zones d'encre M1 et au moins une partie de la surface de la couche d'encre P1, et l'on consolide totalement les couches d'encre M1 et d'encre M2 ;
- au cours d'une 4^{ème} étape, on élimine totalement la couche P1 et l'on obtient un microcomposant constitué par un film de matériau M2 supporté par deux plots de matériau M1.

Les figures 3a et 3b illustrent un cas particulier de ce second mode de mise en oeuvre du procédé pour l'élaboration d'un élément de type "pont". La figure 3a est une vue latérale et la figure 3b est une vue par-dessus du substrat lors des différentes étapes.

Tel qu'illustré sur les figures 3a et 3b, le procédé d'élaboration d'un pont présente les caractéristiques suivantes :
• au cours d'une 1^{ère} étape, on dépose sur le substrat initial, une couche d'encre P1 selon un motif Mo1 rectangulaire dont les côtés correspondant à la longueur sont désignés par Lp et les côtés correspondant à la largeur sont désignés par lp ;
• au cours d'une 2^{éme} étape, on dépose sur le substrat une couche d'encre M1 selon un motif Mo2 comprenant deux zones disjointes, puis l'on consolide au moins partiellement la couche d'encre M1, en respectant les conditions suivantes :
   o les zones disjointes sont situées de part et d'autre des longueurs Lp de la couche d'encre P1, et elles forment ensemble un rectangle interrompu par le motif de la couche d'encre P1,
   o chacune desdites zones disjointes est adjacente à l'une des longueurs Lp de la couche d'encre P1 ;
• au cours d'une 3^{éme} étape, on dépose une couche d'encre M2 selon un motif Mo3 rectangulaire qui recouvre sans débordement la surface de la couche d'encre P1 et la surface des deux zones d'encre M1, et l'on consolide totalement le couches d'encre M1 et d'encre M2 ;
• au cours d'une 4^{ème} étape, on élimine totalement la couche P1 et l'on obtient un microcomposant constitué par un film de matériau M2 supporté par deux plots de matériau M1.

Bien entendu, dans cet exemple, les encres M1 et M2 peuvent être identiques ou différentes. Cependant, ce mode de réalisation est particulièrement intéressant lorsque l'on souhaite obtenir un microcomposant dans lequel les plots qui supportent le film et le film lui-même sont constitués par des matériaux différents.

Un élément du type poutre peut être considéré comme la combinaison d'un plot ou d'un mur sur lesquels repose un film.

Selon un 1er exemple, une structure en poutre comprenant un plot supportant un film peut être élaboré par un procédé selon l'invention qui présente les caractéristiques suivantes :
- au cours d'une 1^{ére} étape, on dépose sur le substrat initial, une couche d'encre P1 selon un motif Mo1 ;
- au cours d'une 2^{ème} étape, on dépose sur le substrat et sur la couche P1, une couche d'encre M1 selon un motif Mo2 dont une partie recouvre partiellement le motif Mo1, puis on consolide totalement la couche d'encre M1 ;
- au cours d'une 3^{ème} étape, on élimine totalement la couche P1 et l'on obtient un microcomposant constitué par un film de matériau M1 qui repose sur un plot de matériau M1.

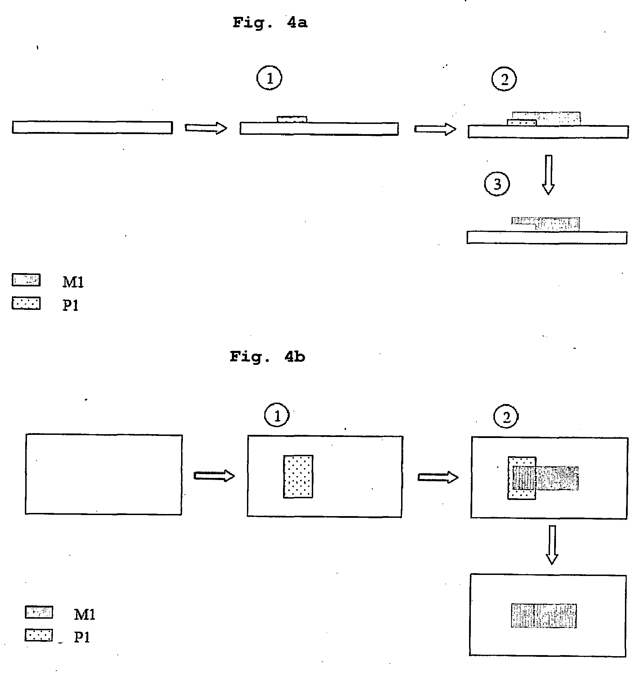

Les figures 4a et 4b illustrent un cas particulier de ce premier mode de mise en oeuvre du procédé pour l'élaboration d'un élément de type "poutre". La figure 4a est une vue latérale et la figure 4b est une vue par-dessus du substrat lors des différentes étapes.

Tel qu'illustré sur les figures 4a et 4b, le procédé d'élaboration d'une poutre présente les caractéristiques suivantes :
- au cours d'une 1^{ère} étape, on dépose sur le substrat initial, une couche d'encre P1 selon un motif Mo1 rectangulaire dont les côtés correspondant à la longueur sont désignés par Lp et les côtés correspondant à la largeur sont désignés par lp ;
- au cours d'une 2^{ème} étape, on dépose sur le substrat et sur la couche P1, une couche d'encre M1 selon un motif Mo2 rectangulaire dont les côtés correspondant à la longueur sont désignés par Lm et les côtés correspondant à la largeur sont désignés par lm, puis on consolide totalement la couche d'encre M1, avec les conditions suivantes :
   o Lp et lm sont parallèles entre eux ;
   o lp et Lm sont parallèles entre eux ;
   o Lp≥lm
   o la position relative des motifs est telle que l'un des côtés lm est compris dans le motif rectangulaire délimité par les côtés Lp,lp et l'autre côté lm est en dehors dudit motif ;
- au cours d'une 3^{ème} étape, on élimine totalement la couche P1 et l'on obtient un microcomposant constitué par un film de matériau M1 qui repose sur un plot de matériau M1.

Selon un 2ème mode de réalisation, une structure en poutre comprenant un plot supportant un film peut être élaboré par un procédé qui présente les caractéristiques suivantes :
- au cours d'une 1^{ère} étape, on dépose sur le substrat initial, une couche d'encre P1 selon un motif Mo1 ;
- au cours d'une 2^{ème} étape, on dépose sur le substrat une couche d'encre M1 selon un motif Mo2 adjacent au motif Mo1 sur une partie de sa périphérie, puis l'on consolide au moins partiellement la couche d'encre M1 ;
- au cours d'une 3^{éme} étape, on dépose une couche d'encre M2 selon un motif M3 qui recouvre la surface de la couche d'encre M1 et une partie de la surface de la couche d'encre P1 sans débordement, et l'on consolide totalement le couches d'encre M1 et d'encre M2 ;
- au cours d'une 4^{ème} étape, on élimine totalement la couche P1 et l'on obtient un microcomposant constitué par un film de matériau M2 qui repose sur un plot de matériau M1.

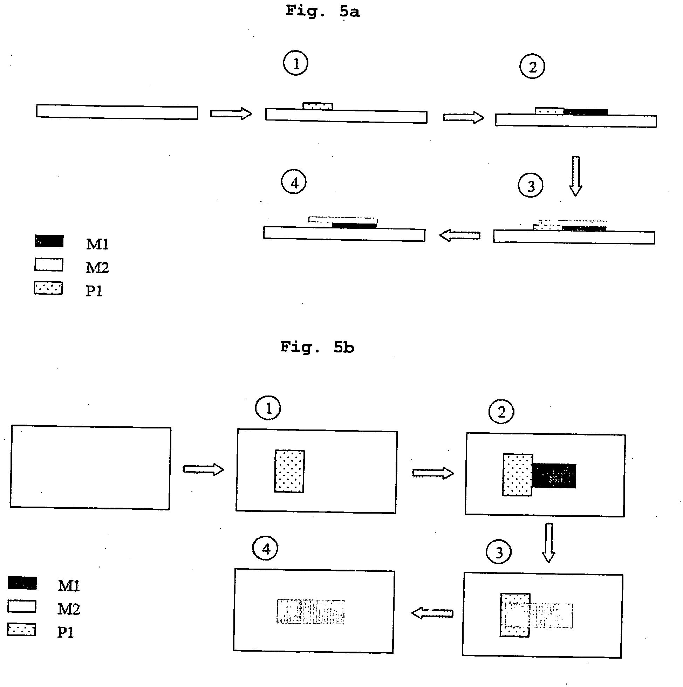

Les figures 5a et 5b illustrent un cas particulier de ce second mode de mise en oeuvre du procédé pour l'élaboration d'un élément de type "poutre". La figure 5a est une vue latérale et la figure 5b est une vue par-dessus du substrat lors des différentes étapes.

Tel qu'illustré sur les figures 5a et 5b, le procédé d'élaboration d'une poutre présente les caractéristiques suivantes :
- au cours d'une 1^{ère} étape, on dépose sur le substrat initial, une couche d'encre P1 selon un motif Mo1 rectangulaire dont les côtés correspondant à la longueur sont désignés par Lp et les côtés correspondant à la largeur sont désignés par Ip ;
- au cours d'une 2^{ème} étape, on dépose sur le substrat une couche d'encre M1 selon un motif Mo2 rectangulaire dont les côtés correspondant à la longueur sont désignés par Lm et les côtés correspondant à la largeur sont désignés par lm, puis l'on consolide au moins partiellement la couche d'encre M1, en respectant les conditions suivantes :
   o Lp et lm sont parallèles entre eux ;
   o lp et Lm sont parallèles entre eux ;
   o lm≤Lp ;
   o l'un des côtés lm est adjacent à l'un des côtés Lp, et l'autre côté lm est à l'extérieur du motif (Lp,lp)
- au cours d'une 3^{ème} étape, on dépose une couche d'encre M2 selon un motif Mo3 rectangulaire qui recouvre la surface de la couche d'encre M1 et une partie de la surface de la couche d'encre P1 sans débordement, et l'on consolide totalement le couches d'encre M1 et d'encre M2 ;
- au cours d'une 4^{ème} étape, on élimine totalement la couche P1 et l'on obtient un microcomposant constitué par un film de matériau M2 qui repose sur un plot de matériau M1.

Comme dans le cas précédent, cet exemple est particulièrement intéressant lorsque les encres M1 et M2 différentes, lorsque l'on souhaite obtenir un microcomposant dans lequel le plot qui supporte le film et le film lui-même sont constitués par des matériaux différents.

Les exemples décrits en relation avec les figures 4a et 4b d'une part, et les figures 5a et 5b d'autre part, permettent d'obtenir un microcomposant comprenant un film de matériau M2 supporté à l'une de ses extrémités par un plot de matériau M1, les deux matériaux pouvant être identiques ou différents.

Des procédés similaires permettent d'obtenir un film de matériau M2 supporté par un plot de matériau M1 non pas à l'une de ses extrémités, mais dans une partie centrale.

Selon un exemple, une structure en poutre comprenant un plot central supportant un film peut être élaboré par un procédé qui présente les caractéristiques suivantes :
- au cours d'une 1^{ère} étape, on dépose sur le substrat initial, une couche d'encre P1 selon un motif Mo1 comprenant deux zones disjointes ;
- au cours d'une 2^{éme} étape, on dépose sur le substrat et sur la couche P1, une couche d'encre M1 selon un motif Mo2 qui recouvre partiellement une partie de chaque zone du motif Mo1 ;
- au cours d'une 3^{ème} étape, on élimine totalement la couche P1 et l'on obtient un microcomposant constitué par un film de matériau M2 qui repose sur un plot de matériau M1.

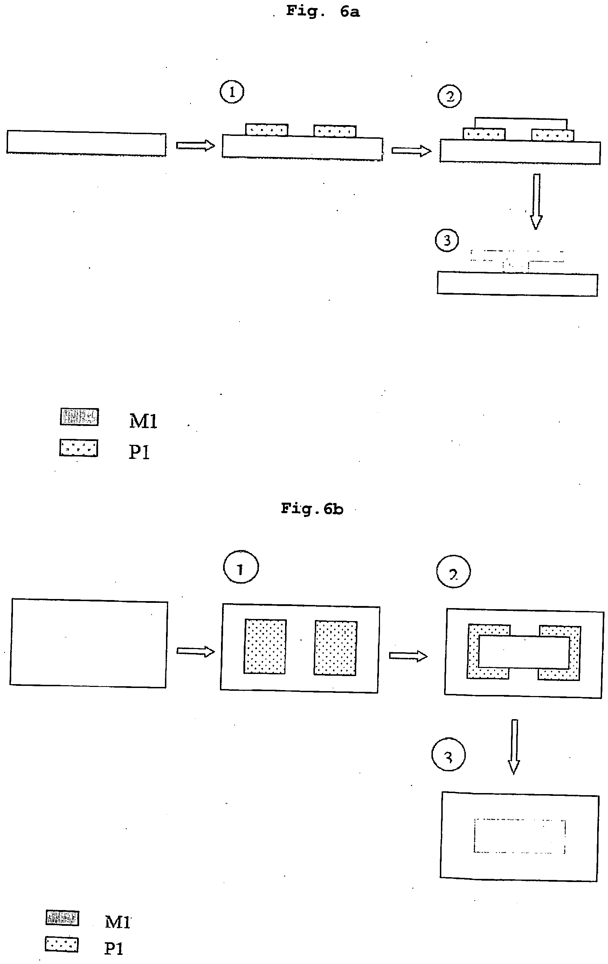

Les figures 6a et 6b illustrent un cas particulier de ce mode de mise en oeuvre du procédé pour l'élaboration d'une poutre supportée par un plot central. La figure 6a est une vue latérale et la figure 6b est une vue par-dessus du substrat lors des différentes étapes.

Tel qu'illustré sur les figures 6a et 6b, le procédé d'élaboration d'une poutre présente les caractéristiques suivantes :
- au cours d'une 1^{ère} étape, on dépose sur le substrat initial, une couche d'encre P1 selon un motif Mo1 comprenant deux rectangles identiques dont les côtés correspondant à la longueur sont désignés par Lp et les côtés correspondant à la largeur sont désignés par lp, les deux rectangles Lp,lp s'inscrivant eux-mêmes dans un rectangle ;
- au cours d'une 2^{ème} étape, on dépose sur la partie du substrat entre les deux zones de la couche P1 et sur la couche P1, une couche d'encre M1 selon un motif Mo2 rectangulaire dont les côtés correspondant à la longueur sont désignés par Lm et les côtés correspondant à la largeur sont désignés par lm, puis l'on consolide au moins partiellement la couche d'encre M1, en respectant les conditions suivantes :
   o Lp et lm sont parallèles entre eux ;
   o lp et Lm sont parallèles entre eux ;
   o lm≤Lp ;
   o l'un des côtés lm est compris dans l'un des rectangles Lp, lp et l'autre côté lm est compris dans l'autre rectangle Lp, lp ;
- au cours d'une 3^{ème} étape, on élimine totalement la couche P1 et l'on obtient un microcomposant constitué par un film de matériau M2 qui repose sur un plot de matériau M1.

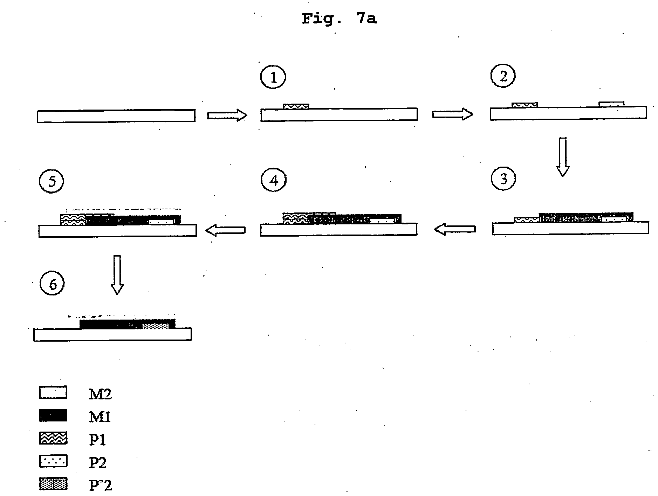

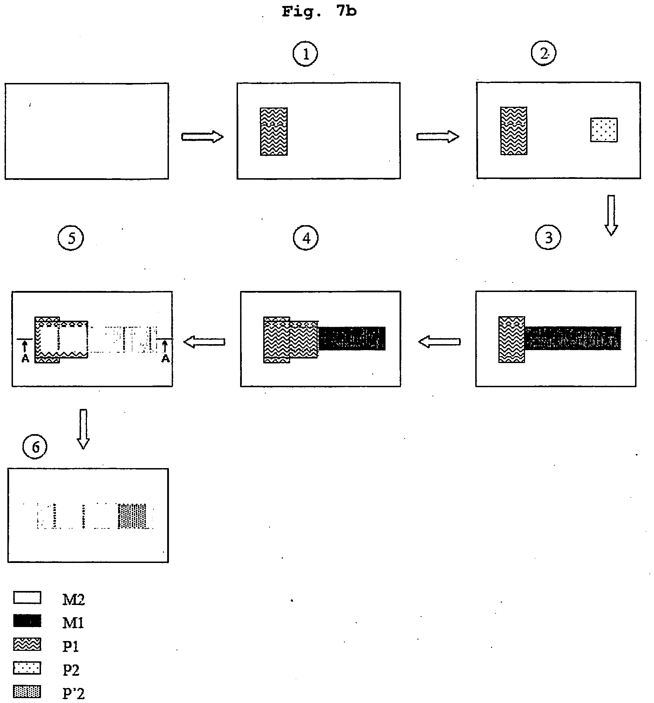

Les figures 7a et 7b illustrent un procédé exemplaire dans lequel on obtient un microcomposant associant un élément de type pont et un élément de type poutre. Le procédé est caractérisé en ce que :
- au cours de la 1^{ère} étape, on dépose sur un substrat une encre P1 sur une zone 1 destinée à servir de support à la formation de l'élément poutre ;
- au cours de la 2^{ème} étape, on dépose sur ledit substrat, une encre P2 sur une zone 2 disjointe de la zone 1 et destinée à servir de support à la paroi supérieure du pont ;
- au cours de la 3^{ème} étape, on dépose une couche d'encre M1 selon un motif décrit en référence aux figures 2a et 2b pour la formation d'un pont, et on consolide au moins partiellement ladite couche ;
- au cours de la 4^{ème} étape, on dépose une couche d'encre P1 sur la couche d'encre M1, à l'extrémité de la couche M1 qui est en contact avec la couche d'encre P1 déposée lors de la 1^{ère} étape ;
- au cours de la 5^{ème} étape, on dépose une couche d'encre M2 selon un motif décrit en référence aux figures 4a et 4b pour la formation d'une poutre, et on consolide totalement les couches M1 et M2 ;
- au cours de la 6^{ème} étape, on élimine les couches P1.

Dans cet exemple, les encres P1 et P2 peuvent être identiques ou différentes, et les encres M1 et M2 peuvent être identiques ou différentes.

Suivant l'encre P2 utilisée, le traitement de consolidation des couches M1 et M2 provoque l'élimination totale de l'encre P2 ou une simple dégradation pour former un matériau P'2. Selon l'utilisation prévue pour le microcomposant ainsi obtenu, l'on peut soit conserver le matériau P'2, soit soumettre le microcomposant à une étape supplémentaire visant à éliminer totalement P'2.

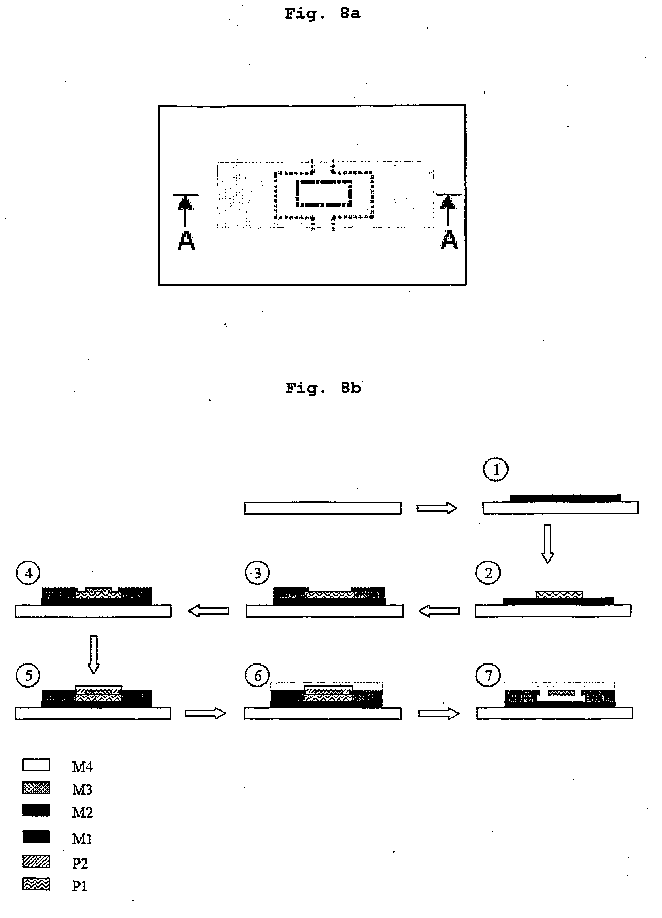

Les figures 8a et 8b illustrent les étapes d'un procédé mis en oeuvre pour l'obtention d'un microcomposant du type cage ouverte. Ledit microcomposant comprend un élément de type pont dans lequel les ponts sont partiellement ouverts, formant une cage ouverte.

La figure 8a est une vue par-dessus du microcomposant fini, qui montre schématiquement les zones dans lesquelles les différentes encres sont déposées.
- La zone rectangulaire la plus grande, délimitée par un trait continu, représente le substrat sur lequel le microcomposant est construit.
- La zone grisée représente le motif selon lequel les encres M1 et M4 destinées à former respectivement la paroi inférieure et la paroi supérieure de la cage sont déposées.
- Les deux zones disjointes délimitées par le contour extérieur de la zone grisée et par les traits en pointillés ...... correspondent au motif selon lequel l'encre M2 destinée à former les parois latérales de la cage est déposée.
- La zone rectangulaire délimitée par la ligne - ● - ● - correspond au motif selon lequel l'encre M3 destinée à former l'objet libre à l'intérieur de la cage est déposée.
- La zone délimitée par la ligne ........ représente la zone selon laquelle les encres P1 et P2 sont déposées.

La figure 8b est une vue en coupe latérale selon l'axe A-A des éléments en cours d'élaboration lors des différentes étapes. Tel qu'illustré sur les figures 8a et 8b, le procédé d'élaboration d'un microcomposant formant une cage partiellement fermée et contenant un élément libre présente les caractéristiques suivantes :
- au cours d'une 1^{ère} étape, on dépose sur le substrat une encre M1 selon un motif correspond au fond de la cage, et l'on consolide totalement la couche M1 ;
- au cours d'une 2^{ème} étape, on dépose une encre P1 selon un motif qui correspond à la base de l'espace vide au centre de la cage ;
- au cours d'une 3^{ème} étape, on dépose autour de la couche d'encre P1, une encre M2 selon un motif qui correspond aux parois latérales de la cage ;
- au cours d'une 4^{ème} étape, on dépose une encre M3 sur la zone portant l'encre P1, selon un motif qui correspond à l'élément libre ;
- au cours d'une 5^{ème} étape, on dépose une encre P2 selon un motif correspond à celui de l'encre P1 ;
- au cours d'une 6^{ème} étape, on dépose une encre M4 selon un motif analogue au motif de l'encre M1 ;
- au cours d'une 7^{ème} étape, on élimine totalement les encres P1 et P2 ;
étant entendu que chacune des couches M2 à M4 est consolidée au moins partiellement avant le dépôt de la couche suivante, et qu'une consolidation totale est effectuée avant l'élimination des encres P1 et P2.

Pour l'élaboration d'une cage contenant un élément libre, les encres P1 et P2 peuvent bien entendu être identiques et différentes, de mêmes que les encres M1 à M4.

Par les modes de mise en oeuvre du procédé décrit ci-dessus, les microcomposants sous forme de pont, de poutre, d'éléments pont/poutre combinés, ou de cage sont solidaires du substrat sur lequel ils ont été élaborés. Pour obtenir un élément sous forme libre, il suffit de reproduire les procédés décrits-ci dessus en appliquant la première couche d'encre, non pas directement sur le substrat, mais sur un substrat portant une couche d'encre P préliminaire déposée selon un motif qui contient totalement au moins le motif selon lequel la couche M1 est déposée. L'élimination de cette couche au cours de l'étape finale libère le microcomposant.

Les différents modes de mise en oeuvre du procédé sont donnés ci-dessus à titre d'exemples.

Le procédé proposé est mis en oeuvre utilement pour l'élaboration de divers microsystèmes utilisés en microélectronique, en microrobotique, en micromécanique, en microfluidique, micromagnétique, microthermique, microoptique, microchimique, etc. Lesdits microsystèmes sont utiles notamment dans le domaine automobile, spatial, l'aéronautique, la domotique, la santé, la biologie, l'agroalimentaire, et l'environnement. A titre d'exemples, on peut citer les actionneurs thermiques (utilisables pour la réalisation d'un interrupteur, ou pour la manipulation de micro objets), les résistances chauffantes à l'échelle millimétrique qui sont partiellement désolidarisées de leur support, les supports portant des microcanaux, et les transformateurs piézoélectriques.

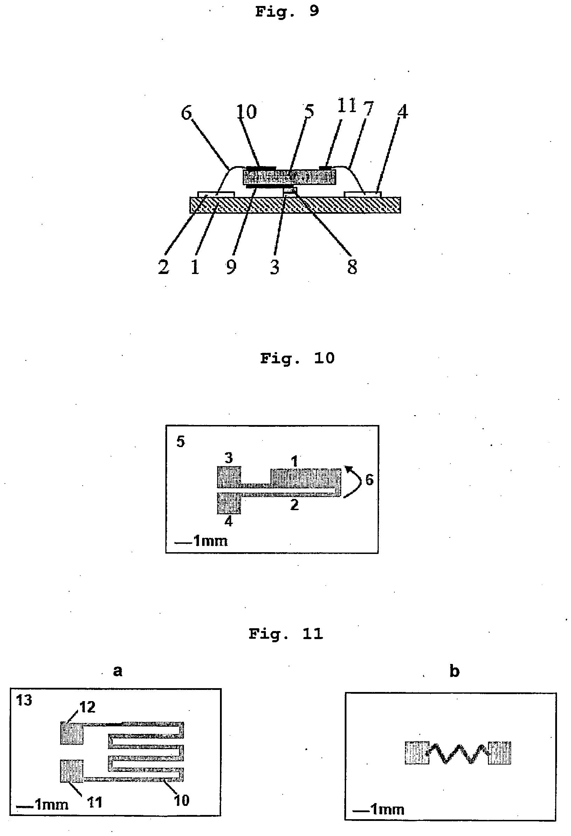

Un exemple de transformateur piézoélectrique est représenté sur la figure 9.

Le transformateur comprend un substrat en alumine (1) sur lequel des électrodes (2,3,4) sont reportées, et un transducteur constitué par une céramique piézoélectrique (5) métallisée et polarisée préférentiellement suivant deux directions.

Le substrat (1) et le transducteur (5) sont connectés électriquement à l'aide des fils (6) et (7) et ils sont rendus solidaires par un plot conducteur électrique (8) déposé par sérigraphie qui assure en outre la liaison électrique entre le substrat et la céramique métallisée.

Le transducteur comprend trois électrodes (9), (10) et (11). Le couple d'électrodes (9) et (10) correspond à la phase primaire du transformateur, et le couple d'électrodes (9) et (11) correspond à la phase secondaire du transformateur.

L'application d'une tension alternative aux bornes des électrodes primaires (9 et 10) induit par effet piézoélectrique inverse une déformation mécanique de la structure qui produit sur les électrodes secondaires (9 et 11) une tension alternative dont l'amplitude est fonction de la géométrie du transducteur et de la fréquence d'utilisation. Lorsque l'excitation est faite pour une fréquence proche de la résonance, les amplitudes vibratoires ainsi que l'énergie de déformation élastique sont importantes. Le transformateur peut alors présenter un rapport de transformation élevé, du fait que ledit rapport de transformation est proportionnel au rapport de la longueur à l'épaisseur de la céramique piézoélectrique.

La figure 10 représente un actionneur thermique, de dimensions millimétriques. L'actionneur comprend deux bras 1 et 2 qui ont la même épaisseur et des largeurs différentes, et deux zones de fixation 3 et 4 sur un substrat 5. L'actionneur est solidaire du substrat 5 par deux plots placés sous les zones de fixation. Lors de son utilisation, le passage du courant provoque une augmentation plus forte de la température dans le bras 2 de plus faible section, ce qui entraîne une dilatation plus grande de ce bras, et par conséquent une déviation horizontale parallèle au substrat, dans le sens indiqué par la flèche (6).

Les figures 11a et 11b représentent deux formes de résistance qui peuvent être obtenues par le procédé de couche épaisse.

Une résistance comprend un filament (10) relié au substrat (13) par deux zones de fixation (11, 12).

Les résistances obtenues par le procédé sont partiellement désolidarisées de leur support, ce qui a pour effet de :
- diminuer la consommation électrique (notamment dans les capteurs et les microréacteurs),
- diminuer les contraintes thermomécaniques exercées sur le substrat par l'échauffement de la résistance (propriété intéressante notamment pour les fusibles, les réseau de résistances-capteurs de température, les capteurs de gaz, les microréacteurs, les micro pompes) ;
- diminuer l'inertie thermique, ce qui est intéressant notamment pour les capteurs et le dégazage.

### Exemple 1

### Actionneur thermique

### Elaboration d'un actionneur thermique

Un actionneur thermique tel que représenté sur la figure 10 a été élaboré selon un procédé de couche épaisse, sur un substrat en alumine.

Les dimensions des bras 1 et 2 sont comme suit :

| Bras | Longueur | Epaisseur | Largeur |
|---|---|---|---|
| 1 | 3,3 mm | 22 µm | 590 µm |
| 2 | 2,4 mm | 22 µm | 140 µm |

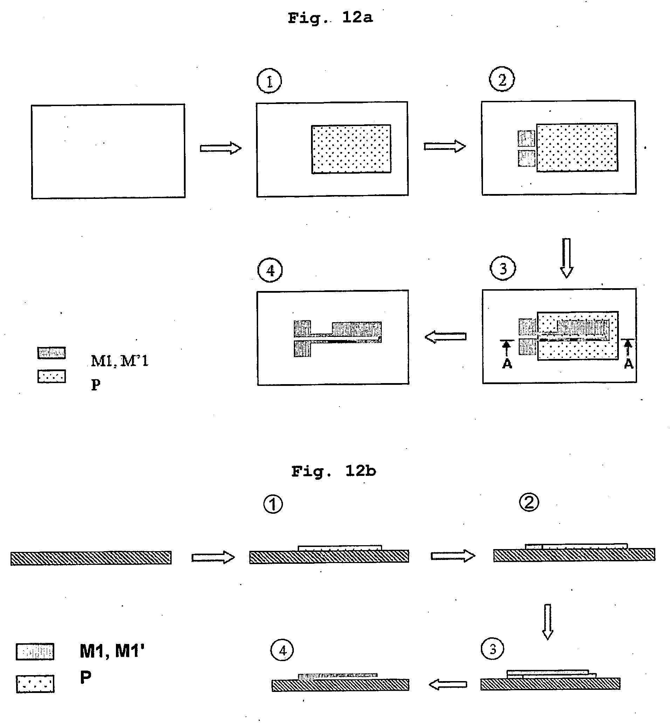

La figure 12a représente les différentes étapes du procédé en vue par-dessus.

La figure 12b représente les étapes du procédé en vue latérale selon l'axe A-A représenté sur la figure 12a.
- Sur un substrat, on dépose au cours de l'étape ①, une couche de matériau P, et l'on consolide ladite couche ;
- au cours de l'étape ②, on dépose à côté de la couche P, une couche de matériau M1 et qui est sous forme de deux zones correspondant aux plots sous les zones 3 et 4 de l'actionneur, et l'on consolide partiellement ladite couche M1 ;
- au cours de l'étape ③, on dépose selon le motif visible sur les fig. 12a et 12b, une couche de matériau M'1 et l'on effectue une consolidation totale ;
- au cours de l'étape ④, on élimine le matériau P, par immersion de courte durée (moins de 1 min) dans une solution aqueuse de H₃PO₄ (1 mol/L).

Quatre essais ont été effectués en utilisant pour chaque essai un substrat en alumine et une encre P contenant 55% SrCO₃ et 45% résine époxy (en poids). Les encres M1 et M'1 utilisées sans les différents essais sont indiquées dans le tableau suivant :
- Essai 1 :: encre à l'argent commercialisée sous la dénomination Ag9912-A par la société ESL ;
- Essai 2 :: encre à l'argent commercialisée sous la dénomination Ag9912-A NB par la société ESL ;
- Essai 3 :: encre au cuivre commercialisée sous la dénomination QP153 par la société Dupont ;
- Essai 4 :: encre au cuivre obtenue à partir d'une poudre de cuivre commercialisée par la société CERAC et d'un véhicule organique commercialisé sous la référence 400 par la société ESL.

Pour chacun des essais, la consolidation de l'encre P au cours de la 1^{ère} étape et la consolidation partielle de l'étape 2 ont été effectuées chacune à 125°C pendant 25 min.

La consolidation totale de l'étape 3 a été effectuée par un traitement thermique de 1 heure comprenant une montée en température de 22 min, un palier de 16 min à la température maximale Tₚ différente selon les essais, puis une descente en température en 22 min. Les températures Tₚ sont données dans le tableau suivant :

| Essai | Tₚ |
|---|---|
| 1 | 850°C |
| 2 | 900°C |
| 3 | 950°C |
| 4 | 950°C |

### Caractérisation des actionneurs thermiques

Les effets de la dilatation des bras de l'actionneur ont été observés. Lorsque le courant est injecté dans les bras de l'actionneur, on observe un déplacement horizontal parallèle au substrat sur l'écran d'un microscope optique (grossissement 20x) comportant un vernier intégré. La précision est de l'ordre de ±3µm

La déviation horizontale observée est de 23 µm pour une puissance injectée de 0,5 W, pour les deux actionneurs en cuivre (obtenus respectivement par les essais 3 et 4), et de 37 µm pour une puissance injectée de 1,8 W pour deux actionneurs en argent (obtenus respectivement par les essais 1 et 2).

### Exemple 2

### Résistances chauffantes

### Elaboration d'une résistance chauffante.

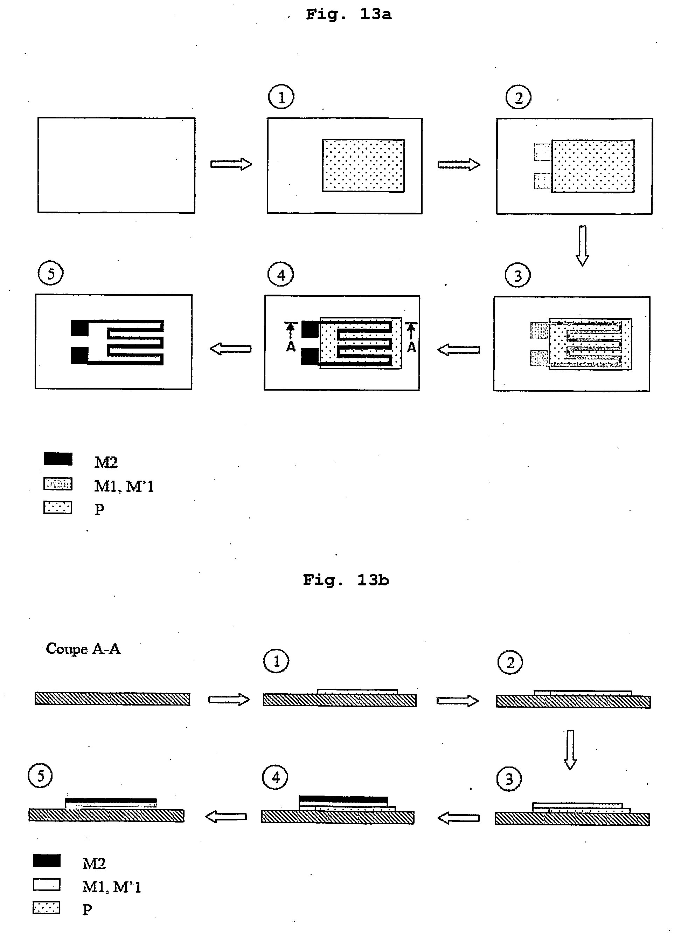

Une résistance telle que représentée sur la figure 13a a été élaborée.

La figure 13a représente les différentes étapes du procédé en vue par-dessus.

La figure 13b représente les étapes du procédé en vue latérale selon l'axe A-A représenté sur la figure 11a.
- Sur un substrat, on dépose au cours de l'étape ①, une couche d'encre P, et l'on consolide ladite couche dans les conditions indiquées dans l'exemple 1 ;
- au cours de l'étape ②, on dépose à côté de la couche P et le long d'un même côté de la couche P, une couche d'encre M1 qui est sous forme de deux zones correspondant aux plots sous les zones 11 et 12 de la résistance (fig. 11a), et l'on consolide partiellement ladite couche M1, dans les conditions indiquées dans l'essai 2 de l'exemple 1 ;
- au cours de l'étape ③, on dépose une couche d'encre M'1. selon le motif visible sur la fig. 13a et représentant la forme du filament, et l'on effectue une consolidation partielle dans les conditions indiquées pour l'essai 2 de l'exemple 1 ;
- au cours de l'étape ④, on dépose une couche d'encre M2 selon le même motif que celui utilisé pour l'encre M'1, et l'on effectue une consolidation totale, dans les conditions indiquées pour l'essai 2 de l'exemple 1 ;
- au cours de l'étape ⑤, on élimine le matériau P dans les conditions indiquées dans l'exemple 1.

Une résistance telle que représentée sur la figure 11b est obtenue par un procédé analogue, avec les différences suivantes :
- lors de l'étape ②, les zones de la couche M1 sont placées le long de deux côtés opposés de la couche P ;
- la couche M'1 destinée à former le filament est déposée selon une ligne brisée joignant les deux zones de couche M1.

Le procédé a été mis en oeuvre en utilisant un substrat en alumine et les encres suivantes :
- Encre P :: encre contenant 55% SrCO₃ et 45% résine époxy (en poids) ;
- Encre M1, M'1 :: encre à l'argent commercialisée sous la dénomination Ag9912-A par la société ESL ;
- Encre M2 :: encre au platine commercialisée sous la référence 5544 par la société ESL.

Le filament des résistances obtenues a une épaisseur de 18 µm, une largeur de 180 µm et une longueur de l'ordre de 20 mm.

### Caractérisation des résistances

Les performances des résistances obtenues ont été testées. Après étalonnage, la résistance a été reliée à un générateur de courant et on a déterminé la puissance injectée qui permet d'atteindre une température comprise entre l'ambiante et des températures proches de la température de fusion.

La puissance de chauffe permettant d'atteindre 500°C à l'aide de la résistance partiellement libérée du substrat selon l'invention représente environ le tiers de la puissance requise par une résistance totalement solidaire du substrat. Pour une puissance de l'ordre de 2,5 W, on observe une cassure du substrat lorsqu'il est en contact direct avec la résistance, alors que la résistance partiellement libérée du substrat fabriquée selon l'invention n'est pas dégradée. Si l'on continue à augmenter la puissance injectée, la résistance selon l'invention rompt par fusion du filament, mais le substrat n'est pas détérioré.

### Exemple 3

### Réalisation de micro canaux

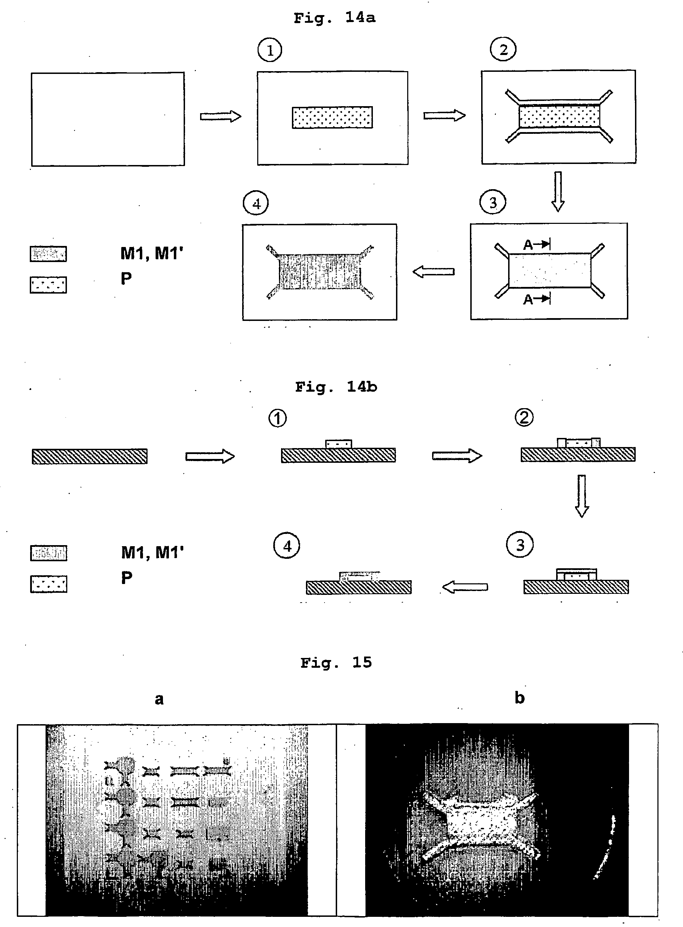

Des microcanaux ont été réalisés selon le processus représenté schématiquement sur les figures 14a et 14b. La figure 14a représente une vue par dessus, et la figure 14b représente une vue latérale suivant l'axe A-A indiqué sur l'étape ③ de la figure 14a.
**•** Sur un substrat, on dépose au cours de l'étape ①, une encre P, et l'on consolide ladite couche dans les mêmes conditions que dans l'exemple 1 ;
**•** au cours de l'étape ②, on dépose le long de deux bords opposés de la couche d'encre P, une couche d'encre M1 qui est sous forme de deux zones correspondant aux parois latérales du microcanal souhaité, et l'on consolide partiellement ladite couche d'encre M1 ;
**•** au cours de l'étape ③, on dépose par-dessus la couche P et la couche M1, une couche d'encre M'1 formant la paroi supérieure du microcanal, et l'on effectue une consolidation totale ;
**•** au cours de l'étape ④, on élimine le matériau P dans les conditions indiquées dans l'exemple 1.

La figure 15a représente une vue par-dessus de quelques structures de microcanaux à base de céramique. Pour l'élaboration de ces structures, on a utilisé les encres suivantes :
- Encre P :: encre contenant 55% SrCO₃ et 45% résine époxy (en poids) ;
- Encre M1, M'1 :: encre diélectrique commercialisée par la société ESL sous la référence 4702. La consolidation partielle de l'étape 2 a été effectuée par une chauffage à 125°C pendant 20 min. La consolidation totale de l'étape 3 a été effectuée par un traitement thermique de 1 heure comprenant une montée en température de 22 min, un palier de 16 min à la température maximale 870°C, puis une descente en température en 22 min.

La figure 15b représente une image d'un microcanal en argent, traversé par un fil de platine de 35 µm de diamètre. Pour l'élaboration du microcanal, on a utilisé les encres suivantes :
- Encre P :: encre contenant 55% SrCO₃ et 45% résine époxy (en poids) ;
- Encre M1 :: encre à l'argent commercialisée sous la dénomination Ag9912-A par la société ESL. La consolidation partielle de l'étape 2 et la consolidation totale de l'étape 3 ont été effectuées dans les conditions indiquées dans l'essai 1 de l'exemple 1.

### Exemple 4

### Assemblage d'un transformateur piézoélectrique

Le procédé de couche épaisse est mis en oeuvre pour l'assemblage d'un transformateur piézoélectrique tel que représenté schématiquement sur la figure 9.

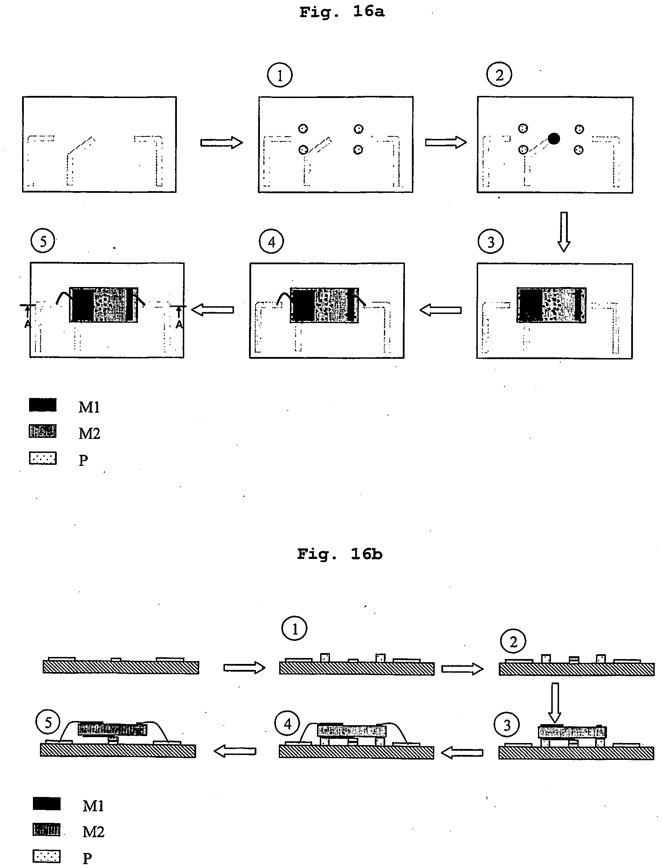

Le processus est représenté schématiquement sur les figures 16a et 16b. La figure 16a représente une vue par-dessus des étapes du procédé, et la figure 16b représente une vue latérale suivant l'axe A-A indiqué sur l'étape 5de la figure 16a.

Les dépôts des couches successives sont effectués sur un substrat d'alumine, sur lequel des pistes conductrices ont été déposées par sérigraphie, puis soumises à une cuisson à 850°C pendant 15 min. Lesdites pistes conductrices correspondent aux électrodes 2, 3 et 4 représentées sur la figure 9.
**•** au cours de l'étape (1), on dépose une encre P sous forme de 4 plots sur le substrat d'alumine prétraité, et l'on consolide dans les conditions indiquées dans l'exemple 1;
**•** au cours de l'étape (2), on dépose une encre M1 selon un motif en forme d'îlot destinée à former le plot 8 de la figure 9 , et l'on consolide partiellement ;
**•** au cours de l'étape (3), on dépose suivant des repères précis, une plaque de céramique métallisée comprenant les électrodes 9, 10 et 11, sur les 4 plots du matériau P et sur le plot 8 d'encre M1 précédemment déposés et l'on consolide partiellement ;
**•** au cours de l'étape (4), avec la couche d'encre M1 et des fils conducteurs électriques, on relie les électrodes du substrat céramique avec celles de la céramique piézoélectrique, et l'on consolide totalement ;
**•** au cours de l'étape (5), on élimine totalement le matériau P dans les conditions indiquées dans l'exemple 1.

Les encres utilisées sont les suivantes :
- Encre P :: encre contenant 55% SrCO₃ et 45% résine époxy (en poids) ;
- Encre M1 :: encre à l'or commercialisée sous la dénomination 8836 par la société ESL.

La consolidation partielle des étapes 2 et 3 a été effectuée par un étuvage à 125°C pendant 20 min. La consolidation totale de l'étape 4 a été effectuée par un traitement thermique de 1 heure comprenant une montée en température de 22 min, un palier de 16 min à la température maximale 850°C, puis une descente en température en 22 min.

### Exemple 5

### Composant piézoélectrique suspendu

### Elaboration du composant

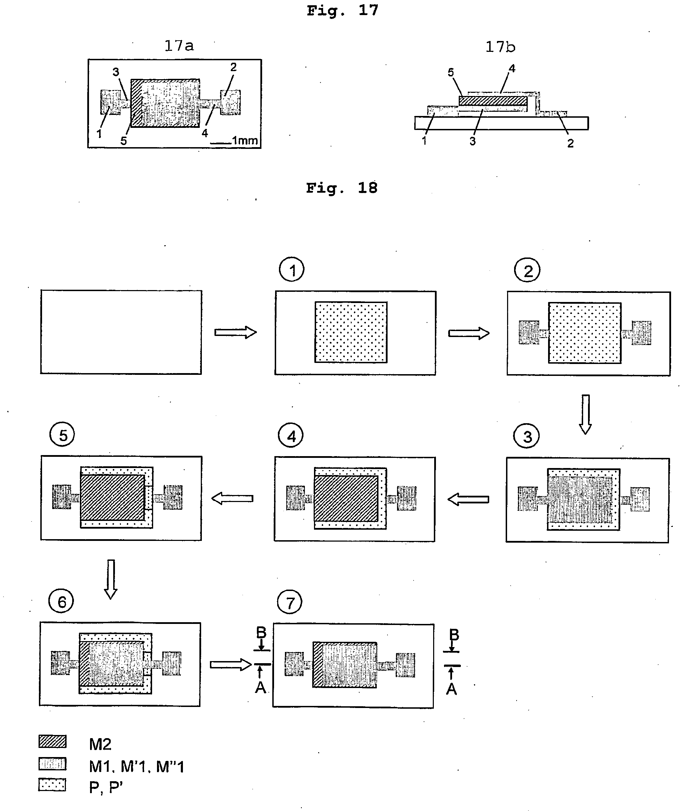

Le composant piézoélectrique visé est représenté schématiquement sur les figures 17a (vue par dessus) et 17b (vue en coupe).

La figure 18 représente les différentes étapes du procédé selon l'invention en vue par-dessus. Les chiffres indiquent le numéro de l'étape du procédé.

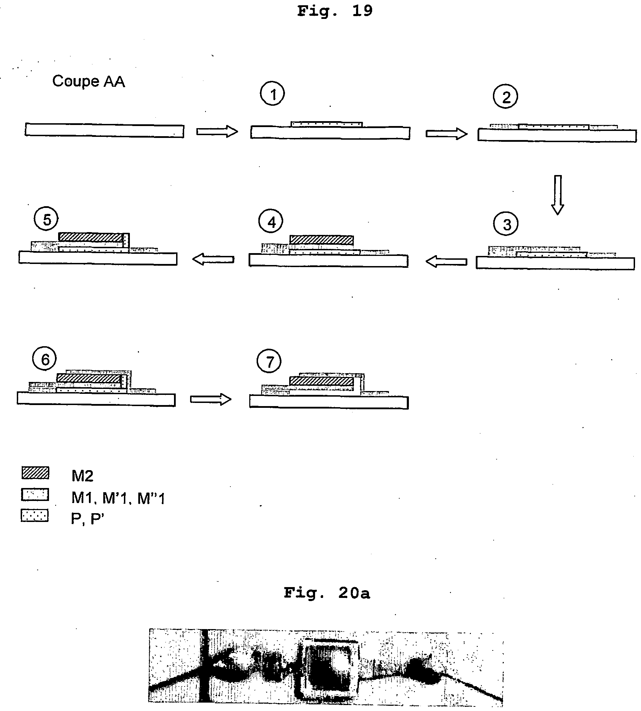

La figure 19 représente les étapes du procédé en vue latérale selon l'axe A-A représenté sur la figure 18.

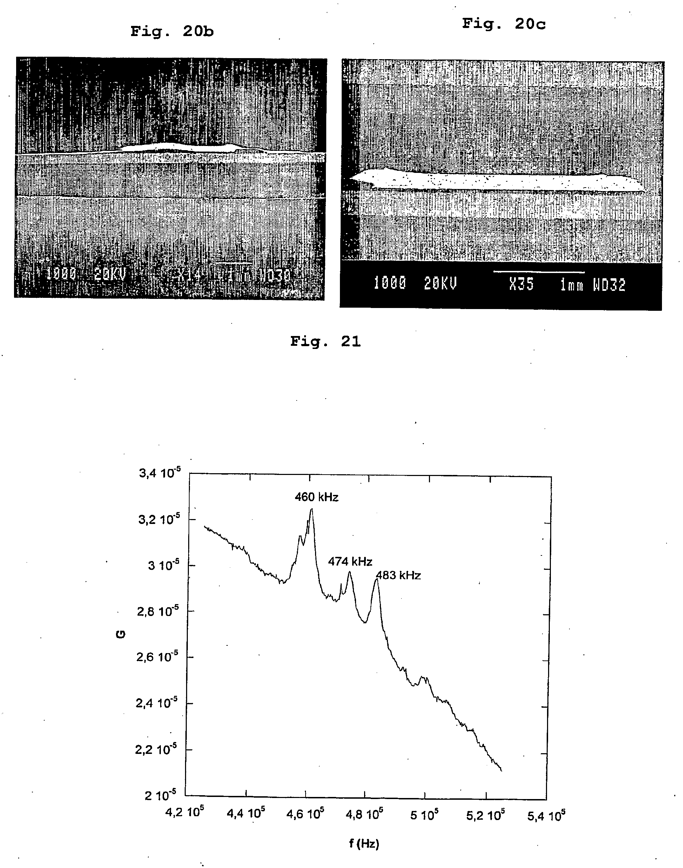

La figure 20a représente une photographie du composant piézoélectrique. Les figures 20b et 20c représentent respectivement une coupe MEB selon l'axe AA et l'axe BB représentés sur la figure 18.

Le composant a été élaboré selon le procédé suivant :
- Sur un substrat, on dépose au cours de l'étape 1, une couche d'encre P, et l'on consolide ladite couche ;
- au cours de l'étape 2,'on dépose de part et d'autre de la couche P une couche d'encre M1 qui est sous forme de deux zones correspondant aux plots sous les zones 1 et 2 du composant piézoélectrique (visibles sur les figures 17a et 17b), et l'on consolide partiellement ladite couche M1 ;
- au cours de l'étape 3, on dépose une couche d'encre M'1 selon le motif visible sur la fig. 18 et représentant la forme de l'électrode inférieure, et l'on effectue une consolidation partielle ;
- au cours de l'étape 4, on dépose une couche d'encre M2 selon le même motif que celui utilisé pour l'encre M'1, et l'on effectue une consolidation partielle ;
- au cours de l'étape 5, on dépose une couche d'encre P' selon le motif visible Fig 18 (cette couche d'encre P' permettant d'isoler électriquement les deux électrodes M'1 et M"1) et l'on consolide ladite couche ;
- au cours de l'étape 6, on dépose une couche d'encre M"1 selon le motif visible sur la fig. 18 (cette couche devant être contenue dans le motif de la couche M2 pour éviter les court-circuits entre les électrodes M'1 et M"1) et représentant la forme de l'électrode supérieure, et l'on effectue une consolidation totale ;
- au cours de l'étape 7, on élimine le matériau P jusquà sa disparition complète par immersion totale de l'échantillon dans une solution aqueuse de H₃PO₄ (1 mol/L).

Le procédé a été mis en oeuvre en utilisant un substrat en alumine et les encres suivantes :
- Encres P,P: encre contenant 55% de SrCO₃ et 45% de résine époxy (en poids) ;
- Encres M1,M'1,M"1: encre à l'or commercialisée sous la dénomination Au8836 par la société ESL ;
- Encre M2: encre piézoélectrique réalisée au laboratoire contenant 24% en poids de liant organique ESL400 fourni par la société ESL et 76% en poids de poudre constituée par 96% en poids de PbZr_{0,5}Ti_{0,5}O₃ (PZT50/50) et 4% en poids d'eutectique PbO/PbF₂.

On a préparé plusieurs composants piézoélectriques de tailles différentes selon le mode opératoire ci-dessus.

Pour chacune des préparations, la consolidation des encres P et P' au cours de la 1^{ère} et la 5^{ième} étape et la consolidation partielle des étapes 2, 3, et 4 ont été effectuées chacune à 125°C pendant 25 min.

La consolidation totale de l'étape 6 a été effectuée par un traitement thermique de 3 heures comprenant deux paliers de température (10 mn à 500°C et 25 mn à 920°C), une montée en température de 75 min, puis une descente en température en 70 mn.

Les électrodes ont une épaisseur de l'ordre de 15 µm et une surface comprise entre 0,1 et 15 mm². La couche du matériau piézoélectrique présente une épaisseur de l'ordre de 80 µm et une surface comprise entre 0,1 et 15 mm².

### Caractérisation du composant piézoélectriques

On a évalué les performances d'un composant piézoélectrique suspendu qui a été obtenu selon le procédé ci-dessus et qui a les dimensions suivantes : 3 mm x 3 mm x 0,08 mm. On a polarisé le composant piézoélectrique pendant 5 mn à 210°C sous 150 V, puis on l'a refroidi jusqu'à 25°C en maintenant la tension de 150 V. La mesure de la conductance en fonction de la fréquence a mis en évidence trois fréquences de résonances. La variation de la conductance du composant en fonction de la fréquence est représentée sur la figure 21.

## Revendications

1. Procédé pour la fabrication d'un microcomposant piézoélectrique suspendu qui comprend une électrode inférieure (3) et une électrode supérieure (4), ledit procédé consistant à :
1) déposer sur un substrat d'alumine, une première couche provisoire d'une encre (P) constituée par une résine thermodurcissable epoxy contenant du SrCO₃ comme charge minérale, et à consolider ladite couche :
2) déposer, de part et d'autre de la première couche provisoire d'encre (P), une première couche d'encre à l'or (M1) sous forme de deux zones, et à consolider partiellement ladite couche (M1) ;
3) déposer une deuxième couche d'encre à l'or (M'1) selon un motif représentant la forme de l'électrode inférieure (3), uniquement au dessus de la première couche provisoire d'encre (P) et de façon que ladite deuxième couche d'encre à l'or (M'1) touche une première desdites deux zones formant la première couche d'encre à l'or (M1), et à consolider partiellement ladite couche (M'1);
4) déposer, uniquement sur la partie de la deuxième couche d'encre à l'or (M'1) représentant l'électrode inférieure (3) une quatrième couche d'encre (M2), ladite quatrième couche contenant un liant organique et une poudre constituée de PbZr_{0,5}Ti_{0,5}O₃ et d'eutectique PbO/PbF₂, et à consolider partiellement ladite couche (M2) ;
5) déposer une deuxième couche provisoire d'encre (P') constituée par une résine thermodurcissable epoxy contenant du SrCO₃ comme charge minérale, pour isoler électriquement les deux électrodes (3, 4), la deuxième couche provisoire d'encre (P') étant disposée directement sur une surface libre de la première couche provisoire d'encre (P) entre la deuxième couche d'encre à l'or (M'1) et la deuxième desdites deux zones formant la première couche d'encre à l'or (M1), et à consolider ladite couche (P') ;
6) déposer une troisième couche d'encre à l'or (M"1), ladite couche étant contenue dans le motif de la quatrième couche d'encre (M2) de façon à toucher la deuxième desdites deux zones formant la première couche d'encre à l'or (M1), la troisième couche d'encre à l'or (M''1) représentant la forme de l'électrode supérieure (4), et à effectuer une consolidation totale, ladite consolidation totale étant effectuée par un traitement thermique ;
7) éliminer ensuite totalement le matériau des deux couches provisoire d'encre (P, P') ;
les encres (M1, M'1, M"1, M2, P et P') étant déposées par coulage ou par extrusion.

2. Procédé selon la revendication 1, **caractérisé en ce que** les différentes couches déposées ont une épaisseur allant de 1 µm à 1 mm.

3. Procédé selon la revendication 1, **caractérisé en ce que** le liant organique d'une encre M contient au moins un liant provisoire, au moins un solvant, éventuellement au moins un composé choisi parmi les gélifiants, les plastifiants, les tensioactifs et les lubrifiants.

4. Procédé selon la revendication 1, **caractérisé en ce que** la consolidation partielle des couches d'encre ( M1, M'1 et M2) est effectuée à une température de 125°C, pendant une durée de 25 min.

## Claims

1. A method for manufacturing a suspended piezoelectric microcomponent which comprises a lower electrode (3) and an upper electrode (4), said method consisting of:
1) depositing on an alumina substrate, a first temporary layer of an ink (P) formed by a thermosetting epoxy resin containing SrCO₃ as a mineral filler, and consolidating said layer:
2) depositing on either side of the first temporary ink layer (P), a first gold ink layer (M1) in the form of two areas, and partly consolidating said layer (M1);
3) depositing a second gold ink layer (M'1) according to a pattern representing the shape of the lower electrode (3), only above the first temporary ink layer (P) and so that said second gold ink layer (M'1) touches a first of said two areas forming the first gold ink layer (M1), and of partly consolidating said layer (M'1);
4) depositing, only on the portion of the second gold ink layer (M'1) representing the lower electrode (3), a fourth ink layer (M2), said fourth layer containing an organic binder and a powder consisting of PbZr_{0.5}Ti_{0.5}O₃ and PbO/PbF₂ eutectic, and partly consolidating said layer (M2);
5) depositing a second temporary ink layer (P') formed by a thermosetting epoxy resin containing SrCO₃ as a mineral filler, in order to electrically insulate both electrodes (3, 4), the second temporary ink layer (P') being directly positioned on a free surface of the first temporary ink layer (P) between the second gold ink layer (M'1) and the second of said two areas forming the first gold ink layer (M1), and partly consolidating said layer (P');
6) depositing a third gold ink layer (M"1), said layer being contained in the pattern of the fourth ink layer (M2) so as to touch the second of said two areas forming the first gold ink layer (M1), the third gold ink layer (M"1) representing the shape of the upper electrode (4), and carrying out total consolidation, said total consolidation being carried out by a heat treatment;
7) then totally removing the material of the two temporary ink layers (P, P');
the inks (M1, M'1, M"1, M2, P and P') being deposited by casting or by extrusion.

2. The method according to claim 1, **characterized in that** the different deposited layers have a thickness ranging from 1 µm to 1 mm.

3. The method according to claim 1, **characterized in that** the organic binder of an ink M contains at least one temporary binder, at least one solvent, optionally, at least one compound selected from gelling agents, plasticizers, surfactants and lubricants.

4. The method according to claim 1, **characterized in that** the partial consolidation of the ink layers (M1, M'1 and M2) is carried out at a temperature of 125°C, for a duration of 25 mins.

## Patentansprüche

1. Verfahren zur Herstellung einer aufgehängten piezoelektrischen Mikrokomponente, die eine untere Elektrode (3) und eine obere Elektrode (4) umfasst, wobei das Verfahren besteht im:
1) Aufbringen einer ersten provisorischen Farbschicht (P), die von einem wärmehärtenden Epoxidharz gebildet wird, das als mineralische Charge SrCO₃ enthält, auf einem Aluminiumoxidsubstrat, und Konsolidieren der Schicht,
2) Aufbringen einer ersten Goldfarbschicht (M1) in Form von zwei Zonen auf der einen und der anderen Seite der ersten provisorischen Farbschicht (P), und teilweises Konsolidieren der Schicht (M1),
3) Aufbringen einer zweiten Goldfarbschicht (M'1) gemäß einem Motiv in Form der unteren Elektrode (3) nur auf der ersten provisorischen Farbschicht (P) und derart, dass die zweite Goldfarbschicht (M'1) eine erste der beiden Zonen, die die erste Goldfarbschicht (1) bilden, berührt, und teilweises Konsolidieren der Schicht (M'1),
4) Aufbringen einer vierten Farbschicht (M2) nur auf dem Teil der zweiten Goldfarbschicht (M'1), die die untere Elektrode (3) darstellt, wobei die vierte Schicht ein organisches Bindemittel und ein Pulver enthält, das aus PbZr_{0,5}Ti_{0,5}O₃ und einem Eutektikum Pb/OPbF₂ besteht, und teilweises Konsolidieren der Schicht (M2),
5) Aufbringen einer zweiten provisorischen Farbschicht (P'), die von einem wärmehärtenden Epoxidharz gebildet wird, das als mineralische Charge SrCO₃ enthält, um die zwei Elektroden (3, 4) elektrisch zu isolieren, wobei die zweite provisorische Farbschicht (P') direkt auf eine freie Fläche der ersten provisorischen Farbschicht (P) zwischen der zweiten Goldfarbschicht (M'1) und der zweiten der zwei Zonen, die die erste Goldfarbschicht (M1) bilden, aufgebracht wird, und Konsolidieren der Schicht (P'),
6) Aufbringen einer dritten Goldfarbschicht (M"1), wobei die Schicht im Motiv der vierten Farbschicht (M2) derart enthalten ist, dass die zweite der zwei Zonen, die die erste Goldfarbschicht (M1) bilden, berührt wird, wobei die dritte Goldfarbschicht (M"1) die Form der oberen Elektrode (4) darstellt, und Durchführen einer vollständigen Konsolidierung durch eine Wärmebehandlung,
7) anschließendes vollständiges Entfernen des Materials der zwei provisorischen Farbschichten (P, P'),
wobei die Farben (M1, M'1, M"1, M2, P und P') durch Gießen oder Extrusion aufgebracht werden.

2. Verfahren nach Anspruch 1, **dadurch gekennzeichnet, dass** die verschiedenen aufgebrachten Schichten eine Dicke von 1 µm bis 1 mm haben.

3. Verfahren nach Anspruch 1, **dadurch gekennzeichnet, dass** das organische Bindemittel einer Farbe M mindestens ein provisorisches Bindemittel, mindestens ein Lösungsmittel, eventuell mindestens eine Verbindung, die aus den Geliermitteln, den Weichmachern, den Tensiden und den Schmiermitteln ausgewählt ist, enthält.

4. Verfahren nach Anspruch 1, **dadurch gekennzeichnet, dass** die teilweise Konsolidierung der Farbschichten (M1, M'1 et M2) bei einer Temperatur von 125 °C während einer Dauer von 25 Minuten durchgeführt wird.
